# EUROPEAN PATENT SPECIFICATION

(11) **EP 1 634 697 B1**
(45) Date of publication and mention of the grant of the patent: **27.08.2014**
(21) Application number: 04732807.5
(22) Date of filing: 13.05.2004
(51) Int. Cl.: B32B 27/06, B32B 9/00, C23C 14/08, C23C 14/10

(54) **TRANSPARENT GAS BARRIER MULTILAYER FILM, ELECTROLUMINESCENT LIGHT-EMITTING DEVICE USING SAME, ELECTROLUMINESCENT DISPLAY, AND ELECTROPHORETIC DISPLAY PANEL**
TRANSPARENTE, MEHRLAGIGE GASSPERRENFOLIE, DIESE VERWENDENDE ELEKTROLUMINESZENZVORRICHTUNG, ELEKTROLUMINESZENZANZEIGE UND ELEKTROPHORETISCHE ANZEIGETAFEL
FILM MULTICOUCHE TRANSPARENT DE BARRIERE GAZEUSE, DISPOSITIF ELECTROLUMINESCENT DOTE DE CE FILM, AFFICHAGE ELECTROLUMINESCENT ET ECRAN ELECTROPHORETIQUE

(30) Priority: 16.05.2003 JP 2003138316
(43) Date of publication of application: 15.03.2006
(73) Proprietor: Toppan Printing Co., Ltd., Taito-ku, Tokyo 110-0016 (JP)
(72) Inventor: YAMAMOTO, Wataru c/o TOPPAN PRINTING CO., LTD., Tokyo 110-0016 (JP)
(74) Representative: TBK
(86) International application number: PCT/JP2004/006808
(87) International publication number: WO 2004/101276

(56) References cited:
- EP-A1- 0 385 054
- EP-A1- 1 298 229
- GB-A- 2 103 999
- JP-A- 9 104 769
- JP-A- 9 123 338
- JP-A- 11 010 725
- JP-A- 2002 234 102
- JP-A- 2002 355 914
- JP-A- 2002 355 915
- JP-A- 2003 053 832
- US-A- 5 324 572

## Description

### Technical Field

The present invention relates to a transparent laminated film having high gas barrier properties against, e.g., oxygen and water vapor, and usable as a packaging material of, e.g., food, medicines, electronic components, and optical components required to have high transparency, and an electroluminescent light-emitting element, electroluminescent display device, and electrophoretic display panel using the same.

### Background Art

Packaging materials used for packaging in the field of food and in the fields of non-food products such as medicines, electronic components, and optical components must prevent the influence of oxygen and water vapor which permeate through the packaging materials and other gases which change the properties of the contents, in order to suppress the changes of properties of the contents and hold their functions and properties, and are required to have, e.g., gas barrier properties of blocking the oxygen, water vapor, and other gases.

For this purpose, metal foils made of metals such as aluminum, metal deposited films, gas barrier resin films having relatively high gas barrier properties such as a vinylidene chloride resin film, a polyvinyl alcohol-ethylene vinyl copolymer film, resin films such as polyacrylonitrile, or laminated films of these resins are conventionally mainly used as gas barrier films.

Unfortunately, although metal foils and metal deposited films have high gas barrier properties, they pose the problems that, e.g., the contents cannot be identified because these foils and films are not transparent, inspection of the contents by a metal detector is impossible, and the used foils and films must be wasted as nonflammable products. Also, gas barrier resin films and their laminated films have a large dependence on the temperature and humidity, so they cannot maintain high gas barrier properties. In addition, vinylidene chloride and polyacrylonitrile may produce harmful materials when disposed of or incinerated.

As packaging materials which have overcome these drawbacks, therefore, gas barrier laminated films, as described in Jpn. Pat. Appln. KOKOKU Publication No. 63-28017, having deposited films obtained by depositing inorganic oxides such as silicon oxide, aluminum oxide, and magnesium oxide on plastic films by formation means such as vacuum deposition and sputtering are put on the market. These deposited films have transparency and gas barrier properties against oxygen, water vapor, and the like.

Normally, these metal deposited films and gas barrier laminated films are often laminated on a film of the same type or a different type, in order to improve their properties or achieve the characteristics of another base material.

For example, Jpn. Pat. Appln. KOKOKU Publication No. 58-42027 proposes a packaging material made of a metal deposited film composite material obtained by laminating metal or metal compound deposited films of the same type or different types on the two surfaces of a 1.5- to 35-µm-thick adhesive layer such that the metal deposited surfaces are positioned inside. As the adhesive layer, various types of polymer adhesives and dry lamination adhesives are used.

In the field of packaging materials, a dry lamination method using a two-part adhesive made up of a main agent and hardener is often used.

In this method, polyol and polyisocyanate, for example, are reacted by using a catalyst, where necessary, to obtain a product having a polymerization degree matching the purpose. Bifunctional polyether or polyester is mostly used as polyol, and tolylenediisocyanate (TDI), diphenylmethanediisocyanate (MDI), hexamethylenediisocyanate (XDI), or isophorinediisocyanate (IPDI) is mostly used as polyisocyanate.

In the dry lamination method using this two-part adhesive, however, when a maturing period called aging is taken after bonding, carbon dioxide (CO₂) gas is produced in a crosslinking/curing process during which a cured coating film grows. When gas barrier films are to be laminated, e.g., when gas barrier films are to be laminated with deposited layer surfaces being positioned inside, this carbon dioxide gas hardly transpires, and fine air bubbles 100 µm or less in diameter resulting from this carbon dioxide (CO₂) gas are formed in the adhesive layer to make it opaque. This poses the problem that this laminated film cannot be used as a packaging material in the fields of packaging of, e.g., food, medicines, electronic components, and optical components required to have high transparency, particularly, in the optical field required to have high transparency.

### Disclosure of Invention

The present invention has been made to solve the problems of the above prior art, and has as its object to provide a gas barrier laminated film having high gas barrier properties against gases such as oxygen and water vapor, and also having high transparency.

It is another object of the present invention to provide an electroluminescent light-emitting element, electroluminescent display device, and electrophoretic display panel sealed by using a gas barrier laminated film having high gas barrier properties against gases such as oxygen and water vapor, and also having high transparency.

According to a first aspect of the present invention, there is provided a transparent gas barrier laminated film according to claim 1 comprising a first transparent gas barrier film, a 1- to 30-µm-thick self-adhesive layer formed on the first transparent gas barrier film, and a second transparent gas barrier film formed on the self-adhesive layer.

According to a second aspect of the present invention, there is provided an electroluminescent light-emitting element comprising
a laminated structure including a transparent electrode layer, an electroluminescent light-emitting layer formed on the transparent electrode layer, one of a dielectric layer and insulating layer formed on the electroluminescent light-emitting layer, and a back electrode layer formed on one of the dielectric layer and insulating layer, and
a transparent gas barrier laminated film according to claim 1 which is sealed to cover the laminated structure and comprises a first transparent gas barrier film, a 1- to 30-µm-thick self-adhesive layer formed on the first transparent gas barrier film, and a second transparent gas barrier film formed on the self-adhesive layer.

According to a third aspect of the present invention, there is provided an electroluminescent display device comprising
a laminated structure including a color filter layer, a transparent electrode layer formed on the color filter layer, an electroluminescent light-emitting layer formed on the transparent electrode layer, one of a dielectric layer and insulating layer formed on the electroluminescent light-emitting layer, and a back electrode layer formed on one of the dielectric layer and insulating layer, and
a transparent gas barrier laminated film according to claim 1 which is sealed to cover the laminated structure and comprises a first transparent gas barrier film, a 1- to 30-µm-thick self-adhesive layer formed on the first transparent gas barrier film, and a second transparent gas barrier film formed on the self-adhesive layer

According to a fourth aspect of the present invention, there is provided an electrophoretic display panel characterized by comprising
a display unit including a transparent electrode layer, a display region containing electrophoretic particles and an insulating fluid which disperses the electrophoretic particles, and a back electrode formed on the display region, and
a transparent gas barrier laminated film according to claim 1 sealed to cover the display unit and comprises a first transparent gas barrier film, a 1- to 30-µm-thick self-adhesive layer formed on the first transparent gas barrier film, and a second transparent gas barrier film formed on the self-adhesive layer.

### Brief Description of Drawings

FIG. 1 is a sectional view showing a first example of a transparent gas barrier laminated film of the present invention;
FIG. 2 is a sectional view showing a second example of the transparent gas barrier laminated film of the present invention;
FIG. 3 is a sectional view showing a third example of the transparent gas barrier laminated film of the present invention;
FIG. 4 is a sectional view showing a fourth example of the transparent gas barrier laminated film of the present invention;
FIG. 5 is a sectional view showing a fifth example of the transparent gas barrier laminated film of the present invention;
FIG. 6 is a sectional view showing a sixth example of the transparent gas barrier laminated film of the present invention;
FIG. 7 is a sectional view showing a seventh example of the transparent gas barrier laminated film of the present invention;
FIG. 8 is a sectional view showing an eighth example of the transparent gas barrier laminated film not according to the present invention;
FIG. 9 is a sectional view showing the arrangement of an example of an electroluminescent light-emitting element of the present invention;
FIG. 10 is a sectional view showing the arrangement of an example of an electroluminescent display device of the present invention; and
FIG. 11 is a sectional view showing the arrangement of an example of an electrophoretic display panel of the present invention.

### Best Mode for Carrying Out the Invention

A transparent gas barrier laminated film of the present invention includes at least two transparent gas barrier films, and a 1- to 30-µm-thick adhesive layer formed on at least one of these transparent gas barrier films, as described in claim 1.

The adhesive layer is formed by using a self-adhesive. This self-adhesive is also called a pressure-sensitive adhesive, and has cohesive force and elasticity. The self-adhesive also has long-term adhesion at room temperature, and can adhere to an object with only a slight pressure without requiring any heat or solvent. The cohesive force herein mentioned is equivalent to a force with which the adhesive resists against internal destruction. The elasticity herein mentioned is equivalent to properties with which an object which has changed its shape or volume restores the original state when the force is removed.

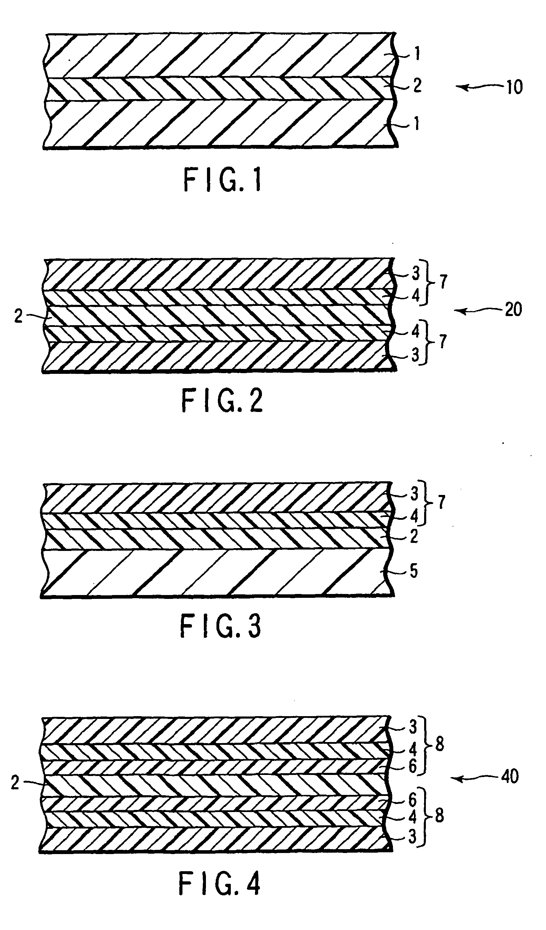

FIG. 1 is a sectional view showing a typical example of the transparent gas barrier laminated film of the present invention.

As shown in FIG. 1, a transparent gas barrier laminated film 10 has an arrangement in which two transparent gas barrier films 1 are laminated via a self-adhesive layer 2.

In the present invention, a transparent gas barrier laminated film can be easily obtained by adhering the two transparent gas barrier films by using this self-adhesive layer, without producing any air bubbles which pose the problem in the conventional dry lamination. Also, since the self-adhesive layer is elastic, the obtained gas barrier laminated film has very strong nerve, hardly cracks by external stress, and is easy to handle, when compared to gas barrier laminated films formed by the dry lamination.

Also, the transparent gas barrier laminated film having high transparency and strong nerve as described above is suitably used as a packaging material of, e.g., food, medicines, and electronic components, or as an optical element of an optical component, and can prevent the invasion of external water or oxygen, thereby preventing changes of properties and defects caused by internal oxygen or moisture.

As the self-adhesive layer used in the present invention, a self-adhesive layer having high transparency is used. Examples of components of the self-adhesive forming the self-adhesive layer are acryl-based, rubber-based, urethane-based, vinylether-based, and silicone-based components, and the form of the self-adhesive is a solvent type, emulsion type, hot melt type, or ultraviolet curing type. An acryl-based resin primarily made of an acryl-based premonomer or acryl-based monomer is particularly favorable in, e.g., transparency and weathering resistance.

As the acryl-based resin, it is possible to use a resin obtained by polymerizing, by an arbitrary method, a material which contains a vinyl monomer containing an acryl group, a vinyl monomer having an epoxy group, a vinyl monomer having an alkoxyl group, a vinyl monomer having an ethyleneoxide group, a vinyl monomer having an amino group, a vinyl monomer having an amide group, a vinyl monomer having a halogen atom, a vinyl monomer having a phosphoric acid group, a vinyl monomer having a sulfonic acid group, a vinyl monomer having a silane group, a vinyl monomer having a phenyl group, a vinyl monomer having a benzyl group, a vinyl monomer having a tetrahydrofurfuryl group, or another copolymerizable monomer.

To improve the adhesive properties of the above acryl-based resin, it is possible to add, if necessary, various types of additives, e.g., a natural resin such as rosin, modified rosin, a derivative of rosin or modified rosin, a polyterpene-based resin, a terpene modified material, an aliphatic hydrocarbon resin, a cyclopentadiene-based resin, an aromatic petroleum resin, a phenol-based resin, an alkyl-phenol-acetylene-based resin, a chmaron-indene-based resin, a tackifier such as a vinyltoluene-α-methylstyrene copolymer, an aging inhibiting agent, a stabilizer, and a softener. Two or more types of these additives may also be used together if necessary. Also, to increase the light resistance, an organic ultraviolet absorbent such as a benzophenone-based or benzotriazole-based absorbent can be added to the self-adhesive.

As a method of forming the adhesive layer, it is possible to coat the lamination surface of one base material to be laminated with the self-adhesive, and form a self-adhesive layer by drying the self-adhesive if necessary.

A reverse roll coater, knife coater, bar coater, slot die coater, air knife coater, reverse gravure coater, vario-gravure coater, or the like is used as a coating apparatus of the self-adhesive. The coating amount of the self-adhesive is desirably 1 to 30 µm is thickness.

After the self-adhesive layer is formed on one transparent gas barrier film as described above, a transparent gas barrier laminated film can be formed by placing the other transparent gas barrier film, and applying an arbitrary pressure.

The transparent gas barrier film described above preferably has a water vapor permeability of 0 to 50g/m² · day, or an oxygen permeability of 0 to 50 cc/cm² · day · atm.

The water vapor permeability herein used can be measured in accordance with JIS K7129B by using a water vapor permeability measurement apparatus (Permatran 3/31 manufactured by Modern Control) at a temperature of 40°C and a humidity of 90%RH.

Also, the oxygen permeability herein used can be measured in accordance with JIS K7126B by using an oxygen permeability measurement apparatus (Oxtran 2/20 manufactured by Modern Control) at a temperature of 30°C and a humidity of 70%RH.

The thickness of the transparent gas barrier film is preferably 9 to 50 µm. If the thickness is less than 9 µm, film formation becomes difficult, and this often causes film defects. If the thickness exceeds 50 µm, the processing efficiency of, e.g., the deposition process or lamination process often decreases.

As at least one of the two transparent gas barrier films, an inorganic oxide deposited film including a base material, and an inorganic oxide deposited layer deposited on the base material is used.

FIG. 2 is a sectional view showing a modification of the transparent gas barrier laminated film shown in FIG. 1.

As shown in FIG. 2, a transparent gas barrier laminated film 20 has an arrangement in which each of two transparent gas barrier films is an inorganic oxide deposited film 7 including a base material 3, and an inorganic oxide deposited layer 4 deposited on the base material 3, and the inorganic oxide deposited layers 4 are laminated via a self-adhesive layer 2.

As the base material of the inorganic oxide deposited film used in the present invention, a polyester film such as a polyethyleneterephthalate (PET) film, polyethylenenaphthalate (PEN) film, or polybutyleneterephthalate (PBT) film is preferably used. A polyethyleneterephthalate (PET) film which is biaxially freely oriented is particularly preferably used from the viewpoint of, e.g., the heat resistance. Well-known various additives, stabilizers, and the like may also be added to this base material. Examples of the additives and stabilizers are an antistatic agent, plasticizer, and lubricant. In addition, to improve the adhesion when other layers are laminated on this base material, preprocessing can be performed on the lamination surface side of the base material. As this preprocessing, it is possible to perform any of corona processing, low-temperature plasma processing, ion bombardment, chemical processing, and solvent processing.

The thickness of the base material is preferably 9 to 50 µm.

As the inorganic oxide, examples of the deposited layer made of the inorganic oxide are aluminum oxide, silicon oxide, tin oxide, magnesium oxide, and mixtures of these materials. The inorganic oxide deposited layer desirably has transparency, and gas barrier properties against oxygen or water vapor. More favorably, it is possible to use one or two or more types of aluminum oxide, silicon oxide, and magnesium oxide.

Although the optimum conditions depend on the type of organic compound used and the arrangement of the deposited layer, the thickness of the inorganic oxide deposited layer is preferably 5 to 300 nm. If the thickness is less than 5 nm, no uniform film can be obtained, and the gas barrier properties often deteriorate. If the thickness exceeds 300 nm, the flexibility of the inorganic oxide deposited film decreases, so the film often cracks by an external cause such as bending or tension after being formed. The thickness of the inorganic oxide deposited layer is preferably 10 to 150 nm.

Conventional vacuum deposition can be used as a method of forming the inorganic oxide deposited film on the polyester film base material. It is also possible to use other thin film formation methods such as sputtering, ion plating, and plasma vapor deposition (CVD). When the productivity is taken into consideration, vacuum deposition can be preferably used. As a heating means of vacuum deposition, one of electron beam heating, resistance heating, and induction heating is favorable. In addition, to increase the adhesion between the deposited layer and base material and the denseness of the deposited layer, deposition may also be performed using a plasma assist method or ion beam assist method. Furthermore, it is also possible to perform reactive deposition by which oxygen gas or the like is blown, in order to increase the transparency of the deposited film.

When the inorganic oxide deposited film as described above is used, a gas barrier laminated film having good gas barrier properties and high transparency is obtained.

With the inorganic oxide deposited film, another gas barrier film, e.g., a transparent gas barrier resin layer can be laminated on the other transparent gas barrier film.

FIG. 3 is a sectional view showing a modification of the transparent gas barrier laminated film shown in FIG. 1.

As shown in FIG. 3, a transparent gas barrier laminated film 30 has an arrangement in which one transparent gas barrier film is an inorganic oxide deposited film 7 including a base material 3, and an inorganic oxide deposited layer 4 formed on the base material 3, the other transparent gas barrier film is a transparent gas barrier resin layer 5, and the transparent gas barrier resin layer 5 and the inorganic oxide deposited layer 4 of the inorganic oxide deposited film are laminated via a self-adhesive layer 2.

Examples of gas barrier resin applied to the transparent gas barrier film are a polyvinyl alcohol copolymer (PVOH), ethylene vinyl alcohol copolymer (EVOH), and vinylidene chloride film (PVDC).

Also, each transparent gas barrier film preferably has a thickness of 9 to 50 µm. If the thickness is less than 9 µm, film formation becomes difficult, and a film defect often occurs. If the thickness exceeds 50 µm, the processing efficiency of, e.g., the lamination process often decreases.

As a transparent gas barrier laminated film, the above-mentioned transparent gas barrier resin layer, inorganic oxide deposited film, and the like can be used in the form of a laminated structure. Examples of the laminated structure are a multilayered structure including a plurality of transparent gas barrier resin layers, a multilayered structure including a plurality of inorganic oxide deposited films, a laminated structure of a transparent gas barrier resin layer and inorganic oxide deposited film, a laminated structure of a transparent gas barrier resin layer or inorganic oxide deposited film and another resin layer, and a multilayered structure of this laminated structure.

As another resin layer used in the transparent gas barrier film, a gas barrier coating layer can be preferably used.

FIG. 4 is a sectional view showing a modification of the transparent gas barrier laminated film shown in FIG. 1.

As shown in FIG. 4, a transparent gas barrier laminated film 40 has an arrangement in which each of two transparent gas barrier films is a composite film 8 including a base material 3, an inorganic oxide deposited layer 4 deposited on the base material 3, and a first gas barrier coating layer 6 formed on the inorganic oxide deposited layer 4, and the two composite films 8 are laminated via a self-adhesive layer 2.

An example of the gas barrier coating layer is a layer formed by applying a coating agent containing, as its main agent, an aqueous solution or a water/alcohol solution mixture which contains a water-soluble polymer and at least one of (a) one or more types of metal alkoxides or/and their hydrolyzed products and (b) tin chloride, and drying the coating agent by heating.

For example, a solution obtained by dissolving a water-soluble polymer and tin chloride in an aqueous (water or water/alcohol mixed) solvent, or a solution obtained by directly mixing metal alkoxide in the above solution or mixing metal alkoxide having undergone processing such as hydrolysis in the above solution, is prepared as a coating agent. After the inorganic oxide deposited layer 4 is coated with this coating agent, the coating agent is dried by heating. The individual components contained in this coating agent will be described in more detail below.

Examples of the water-soluble polymer used in the coating agent of the present invention are polyvinylalcohol, polyvinylpyrrolidone, starch, methylcellulose, carboxymethylcellulose, and sodium alginate. Polyvinylalcohol (PVA) can be preferably used. The gas barrier properties are particularly high when PVA is used. PVA herein mentioned is generally obtained by saponifying polyvinyl acetate, and includes so-called partially saponified PVA in which a few tens percent of an acetic acid group remain, and complete PVA in which only a few percent of an acetic acid group remain.

In addition, tin chloride used in the coating agent may also be stannous chloride (SnCl₂), stannic chloride (SnCl₄), or a mixture of these chlorides. These tin chlorides may also be anhydrides or hydrates.

Furthermore, metal alkoxide is a compound which can be represented by formula M(OR)ₙ (M: a metal such as Si, Ti, Al, or Zr, R: an alkyl group such as CH₃ or C₂H₅)- Specific examples are tetraethoxysilane (Si(OC₂H₅)₄) and triisopropoxy aluminum (Al(O-2'-C₃H₇)₃), and they can be used singly or in the form of a mixture. These compounds are relatively stable in an aqueous solvent after being hydrolyzed.

It is possible to add, where necessary, an isocyanate compound, a silane coupling agent, or a well-known additive such as a dispersant, stabilizer, viscosity modifier, or colorant, within the range over which the gas barrier properties of the coating agent do not deteriorate.

For example, the isocyanate compound to be added to the coating agent preferably has two or more isocyanate groups in its molecule. Examples are monomers such as tolylenediisocyanate, triphenylmethanetriisocyanate, tetramethylxylenediisocyanate, and their polymers and derivatives.

As a coating method of the coating agent, it is possible to use the conventionally known means which is normally used, such as dipping, roll coating, screen printing, spraying, or gravure printing. Although the thickness of the gas barrier coating layer depends on the type of coating agent, the processing machine, and the processing conditions, it is preferably 0.01 to 50 µm, and more preferably, 1 to 15 µm.

If the thickness of the gas barrier coating layer after drying is less than 0.01 µm, no uniform coating film can be obtained, so no satisfactory gas barrier properties can be obtained in many cases. If the thickness exceeds 50 µm, the gas barrier coating layer often cracks easily.

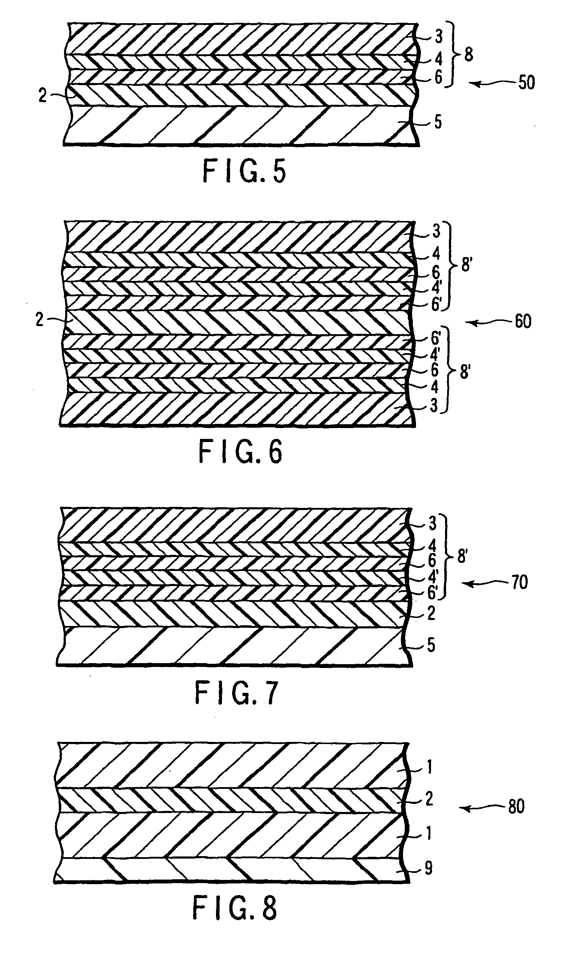

FIG. 5 is a sectional view showing a modification of the transparent gas barrier laminated film shown in FIG. 1.

As shown in FIG. 5, a transparent gas barrier laminated film 50 has an arrangement in which one transparent gas barrier film is a composite film 8 including a base material 3, a first inorganic oxide deposited layer 4 deposited on the base material 3, and a gas barrier coating layer 6 formed on the first inorganic oxide deposited layer 4, the other transparent gas barrier film is a transparent gas barrier resin layer 5, and the transparent gas barrier resin layer 5 and gas barrier coating layer 6 are laminated via a self-adhesive layer 2.

As an application of the inorganic oxide deposited film described above, it is possible to form a first inorganic oxide deposited layer on a base material, form a first gas barrier coating layer on the first inorganic oxide deposited layer, and then deposit a second inorganic oxide deposited layer. In addition, a second gas barrier coating layer can be further formed on the second inorganic oxide deposited layer. A composite film thus obtained by laminating the inorganic oxide deposited layer and gas barrier coating layer on the base material has improved gas barrier properties.

FIG. 6 is a sectional view showing a modification of the transparent gas barrier laminated film shown in FIG. 1.

As shown in FIG. 6, a transparent gas barrier laminated film 60 has an arrangement in which each of two transparent gas barrier films is a composite film 8' including a base material 3, a first inorganic oxide deposited layer 4 deposited on the base material 3, a first gas barrier coating layer 6 formed on the first inorganic oxide deposited layer 4, a second inorganic oxide deposited layer 4' formed on the first gas barrier coating layer 6, and a second gas barrier coating layer 6' formed on the second inorganic oxide deposited layer 4', and the second gas barrier coating layers 6' are laminated via a self-adhesive layer 2.

FIG. 7 is a sectional view showing a modification of the transparent gas barrier laminated film shown in FIG. 1.

As shown in FIG. 7, a transparent gas barrier laminated film 70 has an arrangement in which one transparent gas barrier film is a composite film 8' including a base material 3, a first inorganic oxide deposited layer 4 deposited on the base material 3, a first gas barrier coating layer 6 formed on the first inorganic oxide deposited layer 4, a second inorganic oxide deposited layer 4' formed on the first gas barrier coating layer 6, and a second gas barrier coating layer 6' formed on the second inorganic oxide deposited layer 4', the other transparent gas barrier film is a transparent gas barrier resin layer 5, and the transparent gas barrier resin layer 5 and second gas barrier coating layers 6' are laminated via a self-adhesive layer 2.

A heat-sealing layer may also be formed on at least one of the two principal surfaces of the transparent gas barrier laminated film of the present invention. This heat-sealing layer can be formed as a heat-bonding layer when the transparent deposited film laminated material is to be practically used as, e.g., a packaging material such as a bag, or an optical component.

FIG. 8 is a sectional view showing a modification of the transparent gas barrier laminated film shown in FIG. 1.

As shown in FIG. 8 (not according to the invention), a transparent gas barrier laminated film 80 has an arrangement in which two transparent gas barrier films 1 are laminated via a self-adhesive layer 2, and a heat-sealing layer 9 is further formed on that surface of one transparent gas barrier film 1, which is opposite to the surface laminated on the adhesive layer 2.

Note that as the transparent gas barrier film 1 shown in FIG. 8, it is possible to apply one or more inorganic oxide deposited films 7, transparent gas barrier resin layers 5, composite films 8 and 8', and the like as described above.

With this arrangement, molding by heat sealing using the transparent gas barrier laminated film of the present invention can be easily performed.

As the heat-sealing layer, it is possible to use resins such as polyethylene, polypropyrene, an ethylene-vinyl acetate copolymer, an ethylene-methacrylic acid copolymer, an ethylene-methacrylate copolymer, an ethylene-acrylic acid copolymer, an ethylene-acrylate copolymer, and metal crosslinked products of these resins. Although the thickness is determined in accordance with the purpose, it is generally 15 to 200 µm.

As a method of forming the heat-sealing layer, an extrusion lamination method or the like can be preferably used. However, lamination may also be performed by another known method.

Examples of an adhesive resin used in the extrusion lamination method are an ethylene-vinyl acetate copolymer, ethylene-methacrylic acid copolymer, ethylene-acrylic acid copolymer, ethylene-ethylacrylate acid copolymer, ethylene-methylmethacrylate acid copolymer, and ethylene-methylacrylate acid copolymer. An ethylene-methylmethacrylate acid copolymer (e.g., Nucrel AN4228C (trade name) manufactured by DuPont-Mitsui Polychemicals) by which interlayer adhesion is obtained by direct extrusion lamination on a polyester film base material, without performing anchor coating on the polyester film base material or performing ozone processing on a molten film of an extrusion lamination resin is suitably used.

The transparent gas barrier laminated film of the present invention can be suitably used as a packaging material, optical component, and the like.

An electroluminescent light-emitting element of the present invention is an example when the transparent gas barrier laminated film of the present invention is used as an optical component, and comprises
a laminated structure including a transparent electrode layer, an electroluminescence light-emitting layer formed on the transparent electrode layer, a dielectric layer or insulating layer formed on the electroluminescence light-emitting layer, and a back electrode layer formed on the dielectric layer or insulating layer, and
a transparent gas barrier laminated film sealed to cover the laminated structure, and including a first transparent gas barrier film, a 1- to 30-µm-thick self-adhesive layer formed on the first transparent gas barrier film, and a second transparent gas barrier film formed on the self-adhesive layer.

The electrode layers, insulating layer, dielectric layer, and electroluminescent light-emitting layer can be formed by using well-known methods such as deposition and sputtering.

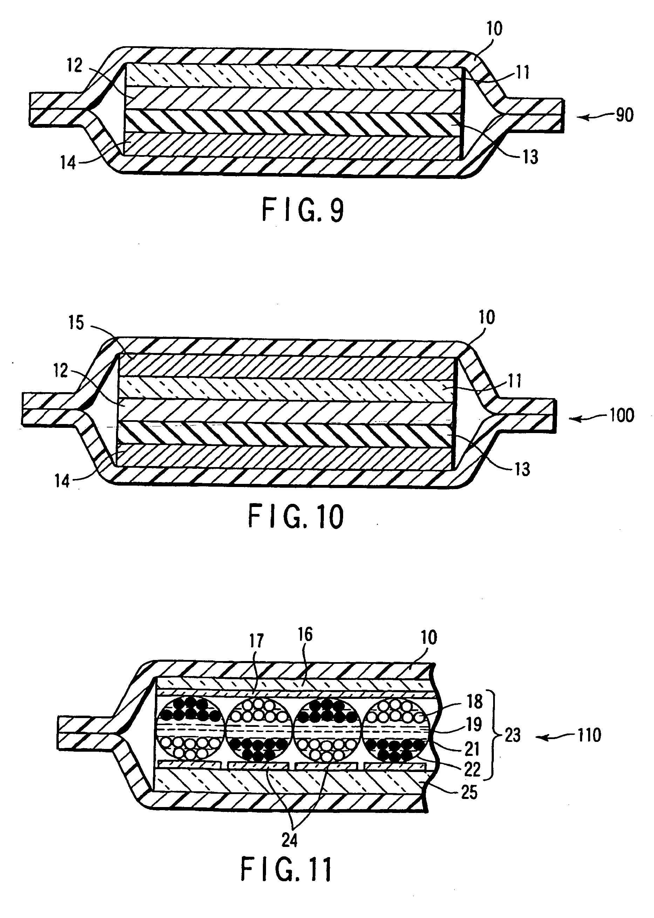

FIG. 9 is a sectional view showing the arrangement of an example of the electroluminescent light-emitting element of the present invention.

As shown in FIG. 9, an electroluminescent light-emitting element 90 comprises a laminated structure including a transparent electrode layer 11 connected to an electrode (not shown) and made of, e.g., indium lead oxide, an inorganic electroluminescent light-emitting layer 12, for example, formed on the transparent electrode layer 11, a dielectric layer 13, for example, formed on the inorganic electroluminescent light-emitting element 12, and a back electrode layer 14 connected to an electrode (not shown) and made of, e.g., a metal, and a sealing film 10 as shown in, e.g., FIG. 8, which is sealed to cover the laminated structure.

Also, an electroluminescent display device is an example of a display device using the electroluminescent light-emitting element described above, and comprises
a laminated structure including a color filter layer, a transparent electrode layer formed on the color filter layer, an electroluminescent light-emitting layer, for example, formed on the transparent electrode, a dielectric layer formed on the electroluminescent light-emitting layer, and a back electrode layer formed on the dielectric layer, and
a transparent gas barrier laminated film according to the invention sealed to cover the laminated structure, and including a first transparent gas barrier film, a 1- to 30-µm-thick self-adhesive layer formed on the first transparent gas barrier film, and a second transparent gas barrier film formed on the self-adhesive layer.

The color filter can be formed by a well-known method, e.g., photolithography.

The electrode layers, insulating layer, dielectric layer, and electroluminescent light-emitting layer can be formed by using well-known methods such as deposition and sputtering.

FIG. 10 is a sectional view showing the arrangement of an example of the electroluminescent display device of the present invention.

As shown in FIG. 10, an electroluminescent display device 100 comprises a laminated structure including a color filter layer 15, a transparent electrode layer 11 formed on the color filter layer 15, connected to an electrode (not shown), and made of, e.g., indium lead oxide, an inorganic electroluminescent light-emitting layer 12, for example, formed on the transparent electrode layer 11, a dielectric layer 13, for example, formed on the inorganic electroluminescent light-emitting element 12, and a back electrode layer 14 connected to an electrode (not shown) and made of, e.g., a metal, and a sealing film 10 as shown in, e.g., FIG. 8, which is sealed to cover the laminated structure.

Furthermore, an electrophoretic display device of the present invention is another example in which the transparent gas barrier laminated film of the present invention is used as an optical part, and comprises
a display unit having a transparent electrode layer, a display region formed on the transparent electrode layer, and containing electrophoretic particles and an insulating fluid which disperses the electrophoretic particles, and a back electrode formed on the display region, and
a transparent gas barrier laminated film sealed to cover the display unit, and including a first transparent gas barrier film, a 1- to 30-µm-thick adhesive layer formed on the first transparent gas barrier film, and a second transparent gas barrier film formed on the adhesive layer.

The display unit can contain, e.g., capsules encapsulating an insulating fluid in which electrophoretic particles are dispersed. Alternatively, an insulating fluid in which electrophoretic particles are dispersed can be encapsulated in regions divided by partitions. A plurality of capsules and divided regions are formed, and they can be arranged into predetermined patterns.

FIG. 11 is a sectional view showing the arrangement of an example of the electrophoretic display panel of the present invention.

As shown in FIG. 11, this electrophoretic display panel comprises a display unit having a transparent glass substrate 25, pixel electrodes 24 formed into a predetermined pattern on the transparent glass substrate 25 and made of, e.g., indium lead oxide, a matrix electrode (not shown), a switching element (not shown), a plurality of microcapsules 23 formed on the pixel electrodes 24, pixel electrodes 17 formed on the microcapsules 23 and made of, e.g., indium lead oxide, and a glass substrate 16 formed on the pixel electrodes 17, and a sealing film 10 sealed to cover this display unit and having, e.g., the same arrangement as shown in FIG. 8.

The microcapsule 23 encapsulates, in a film 22, white particles 18, black particles 19, and an insulating solution 19 which disperses these particles.

The microcapsule 23 can be formed by, e.g., the following method.

First, a dispersion is formed which disperses 100 parts by weight of a tetrachloroethylene solvent, 60 parts by weight of titanium oxide, as white particles, covered with a polyethylene resin which is negatively charged in a solution, and having an average particle size of 3 µm, and 40 parts by weight of carbon black, as black particles, surface-treated by alkyltrimethyl ammonium chloride which is positively charged in a solution, and having an average particle size of 4.0 µm.

Of this dispersion, 40 parts by weight are mixed with an aqueous solution prepared by blending 10 parts by weight of gelatin and 0.1 part by weight of sodium polyethylenesulfonate as an emulsifier in 80 parts by weight of water. After the liquid temperature is adjusted to 40°C, the mixture is stirred by using a homogenizer while the liquid temperature is held, thereby obtaining an O/W emulsion.

Then, the obtained 0/W emulsion and an aqueous solution prepared by blending 10 parts by weight of gum arabic in 80 parts by weight of water adjusted to 40°C are mixed, the pH of the solution is adjusted to 4 by using acetic acid while the liquid temperature of the solution is held at 40°C, and microcapsule walls are formed by coacervation.

Then, the liquid temperature is lowered to 5°C, and 1.9 parts by weight of a 37-wt% formalin solution are added to harden microcapsules. In this manner, microcapsules encapsulating the white particles, the black particles, and the insulating solution which disperses these particles are obtained.

Also, the electrophoretic display panel of the present invention can be formed by forming a transparent electrode made of, e.g., indium lead oxide on one transparent glass substrate by sputtering or the like, applying and drying a coating solution containing the microcapsules and a binder, forming a transparent electrode made of, e.g., indium lead oxide on the other transparent glass substrate by sputtering or the like, and adhering the two glass substrates with the transparent electrodes and microcapsules being positioned inside.

Another resin film may also be laminated, if necessary, on the transparent gas barrier laminated film of the present invention by using a self-adhesive. As this resin film, it is possible to use transparent films, e.g., polyester films such as polyethyleneterephthalate (PET) and polyethylenenaphthalate (PEN), polyolefin films such as polyethylene and polypropyrene, a polystyrene film, a polyamide film, a polycarbonate film, a polyacrylnitrile film, and a polyimide film. These films may or may not be oriented as long as they have mechanical strength and dimensional stability. A polyethyleneterephthalate film biaxially freely oriented is particularly preferably used from the viewpoint of, e.g., the heat resistance. It is also possible to use various well-known additives and stabilizers, e.g., an antistatic agent, ultraviolet inhibitor, plasticizer, and lubricant. In addition, to improve the adhesion to another base material, the lamination surface side of the base material may also undergo any of corona processing, low-temperature plasma processing, ion bombardment, chemical processing, and solvent processing, as preprocessing. Examples

### Example 1

As a base material, a 12-µm-thick biaxially oriented PET film was prepared. This PET film was placed in an electron beam heating type vacuum deposition apparatus, metal aluminum was evaporated, and oxygen gas was supplied to deposit a 15-nm-thick aluminum oxide layer on one surface of the PET film, thereby obtaining a first deposited layer.

Then, the following coating agent was prepared. Preparation of Coating Agent

First, 89.6g of hydrochloric acid (0.1N) were added to 10.4g of tetraethoxysilane, and the mixture was hydrolyzed under stirring for 30 min, thereby preparing a hydrolyzed solution having 3 wt% of a solid content as the amount of SiO₂, as a first solution.

Then, as a second solution, 97 wt% of a water-isopropyl alcohol solution in which water and isopropyl alcohol were mixed at a weight ratio of 90 : 10 and 3 wt% of polyvinyl alcohol were mixed.

A coating solution was obtained by mixing the first and second solutions at a weight mixing ratio of 60 : 40.

The obtained intermediate layer coating solution was applied by gravure coating, and dried at 120°C for 1 min, thereby forming a 5-µm-thick first gas barrier coating layer.

After that, the base material on which the first deposited layer and first gas barrier coating layer were formed was placed in the electron beam heating type vacuum deposition apparatus, metal aluminum was evaporated, and oxygen gas was supplied to deposit a 15-nm-thick aluminum oxide layer, thereby forming a second deposited layer. A transparent laminated structure was obtained by forming a second gas barrier coating layer on the second deposited layer in the same manner as described above.

The water vapor permeability of this inorganic oxide deposited film was 0.04g/m² · day.

Two such inorganic oxide deposited films were prepared, the surface of the second gas barrier coating layer of one inorganic oxide deposited film was coated with a material obtained by adding BXX 5134 (manufactured by Toyo Ink Mfg.) to BPS 5215 (manufactured by Toyo Ink Mfg.) as an acryl-based self-adhesive, such that the thickness was 10 µm after drying, and hot-air drying was performed to obtain an adhesive layer. The surface of the second gas barrier coating layer of the other inorganic oxide deposited film was overlaid on the obtained adhesive layer and adhered by pressure, thereby obtaining a transparent gas barrier laminated film.

The obtained transparent gas barrier laminated film had high transparency, and the transparency was found to have no unevenness.

Also, the film had appropriate elasticity when held in the hand.

The nerve of this transparent gas barrier laminated film was measured as follows.

### Nerve Measurement

Three rectangular test pieces (lateral) 200 mm wide and 15 mm long and three rectangular test pieces (longitudinal) 200 mm long and 15 mm wide were cut out from a long transparent gas barrier laminated film. Each test piece was attached between movable fixing tools on the two sides of a Loop Stiffness Tester manufactured by Toyo Seiki Seisaku-Sho such that the distance between the fixing tools was 150 mm, and the movable fixing tools on the two sides were moved to the center and brought into contact with each other to loop the test piece. After that, the test piece was lowered 90° toward a sensor and moved close to the sensor until the test piece was brought into contact with it, and the strength in this contact state was measured. The average value of the measurement values of the three test pieces was used as the nerve.

Consequently, the nerve of the test pieces (longitudinal) was 1.29g, and that of the test pieces (lateral) was 1.22g.

Also, the obtained transparent gas barrier laminated film was used as a sealing film to assemble an electroluminescent light-emitting element, electroluminescent display device, and electrophoretic display panel having the same arrangements as shown in FIGS. 9, 10, and 11, respectively. As a consequence, the transparency was high, and the laminated film did not crack.

### Comparative Example 1

A second gas barrier coating layer of one inorganic oxide deposited film was coated with an self-adhesive (a main agent: A515 manufactured by Mitsui Takeda Chemicals, a hardener: A50 manufactured by Mitsui Takeda Chemicals) using polyol and polyisocyanate, instead of a self-adhesive, and a gas barrier coating layer of the other inorganic oxide deposited film was laminated on this adhesive by using a dry laminating machine, thereby obtaining a gas barrier laminated film.

Although the obtained gas barrier laminated film had transparency, the transparency was uneven, and a plurality of stripe patterns were visually observable.

Also, the nerve of the obtained gas barrier laminated film was measured following the same procedures as in Example 1. Consequently, the nerve of test pieces (longitudinal) was 0.56g, and that of test pieces (lateral) was 0.55g, i.e., the nerve was much lower than that of Example 1. In addition, the film was hard when held in the hand.

As described above, the gas barrier laminated film of Example 1 was significantly superior to that of Comparative Example 1 in transparency and nerve.

### Industrial Applicability

The transparent gas barrier laminated film of the present invention has high gas barrier properties against oxygen, water vapor, and the like, and also has high transparency. Therefore, this transparent gas barrier laminated film is suitably used as an optical film or packaging material used in the fields of, e.g., food, medicines, electronic components, and optical components required to have high gas barrier properties and high transparency.

## Claims

1. A transparent gas barrier laminated film comprising a first transparent gas barrier film, a 1- to 30-µm-thick self-adhesive layer formed on the first transparent gas barrier film, and a second transparent gas barrier film formed on the self-adhesive layer,
said transparent gas barrier laminated film being **characterized in that** at least one of the first and second transparent gas barrier films comprises a base material, and an inorganic oxide deposited layer deposited on the base material.

2. The transparent gas barrier laminated film according to claim 1, **characterized in that** the first transparent gas barrier film comprises a base material, and an inorganic oxide deposited layer formed on the base material, and the second transparent gas barrier film comprises a gas barrier resin layer.

3. The transparent gas barrier laminated film according to claim 1 or 2, **characterized in that** the inorganic oxide contains at least one member selected from the group consisting of aluminum oxide, silicon oxide, and magnesium oxide.

4. The transparent gas barrier laminated film according to any one of claims 1 to 3, **characterized by** further comprising, on the inorganic oxide deposited layer, a gas barrier coating layer formed by applying a coating agent containing, as a main agent thereof, one of an aqueous solution and a water/alcohol solution mixture which contains a water-soluble polymer and at least one of (a) one or more type of a metal alkoxide and/or a hydrolyzed product thereof and (b) tin chloride, and drying the coating agent by heating.

5. The transparent gas barrier laminated film according to claim 4, **characterized in that** the metal alkoxide contains at least one of tetraethoxysilane and triisopropoxy aluminum.

6. The transparent gas barrier laminated film according to claim 4 or 5, **characterized in that** the water-soluble polymer is polyvinyl alcohol.

7. The transparent gas barrier laminated film according to any one of claims 1 to 6, **characterized by** further comprising a heat-sealing layer formed on at least one of the first and second transparent gas barrier films.

8. An electroluminescent light-emitting element **characterized by** comprising a laminated structure including a transparent electrode layer, an electroluminescent light-emitting layer formed on the transparent electrode layer, one of a dielectric layer and insulating layer formed on the electroluminescent light-emitting layer, and a back electrode layer formed on one of the dielectric layer and insulating layer, and a transparent gas barrier laminated film cited in any one of claims 1 to 7 and sealed to cover the laminated structure.

9. An electroluminescent display device **characterized by** comprising an electroluminescent light-emitting element cited in claim 8, and a color filter layer formed between the transparent electrode layer and the transparent gas barrier laminated film on the transparent electrode layer.

10. An electrophoretic display panel **characterized by** comprising a display unit including a transparent electrode layer, a display region containing electrophoretic particles and an insulating fluid which disperses the electrophoretic particles, and a back electrode formed on the display region, and a transparent gas barrier laminated film cited in any one of claims 1 to 7 and sealed to cover the display unit.

11. The electrophoretic display panel according to claim 10, **characterized in that** the display unit has a capsule encapsulating the insulating fluid in which the electrophoretic particles are dispersed.

## Patentansprüche

1. Laminierter transparenter Gasbarrierefilm, der einen ersten transparenten Gasbarrierefilm, eine 1 bis 30 µm dicke selbstklebende Schicht, die auf dem ersten transparenten Gasbarrierefilm gebildet ist, und einen zweiten transparenten Gasbarrierefilm, der auf der selbstklebenden Schicht gebildet ist, umfasst,
wobei der laminierte transparente Gasbarrierefilm **dadurch gekennzeichnet ist, dass** zumindest eines aus den ersten und zweiten transparenten Gasbarrierefilmen ein Basismaterial und eine anorganisches Oxid-abgeschiedene Schicht, die auf dem Basismaterial abgeschieden ist, umfasst.

2. Laminierter transparenter Gasbarrierefilm nach Anspruch 1, **dadurch gekennzeichnet, dass** der erste transparente Gasbarrierefilm ein Basismaterial und ein anorganisches Oxid-abgeschiedene Schicht, die auf dem Basismaterial gebildet ist, umfasst und der zweite transparente Gasbarrierefilm eine Gasbarriereharzschicht umfasst.

3. Laminierter transparenter Gasbarrierefilm nach Anspruch 1 oder 2, **dadurch gekennzeichnet, dass** das anorganische Oxid zumindest ein Element enthält, das aus der Gruppe ausgewählt ist, die aus Aluminiumoxid, Siliziumoxid und Magnesiumoxid besteht.

4. Laminierter transparenter Gasbarrierefilm nach einem der Ansprüche 1 bis 3, **gekennzeichnet durch** ferner Umfassen, auf der anorganisches Oxid-abgeschiedenen Schicht, einer Gasbarrierebeschichtungsschicht, die durch Aufbringen eines Beschichtungsagens gebildet ist, das als ein Hauptagens davon eines aus einer wässrigen Lösung und einer Wasser- / Alkohollösungsmischung enthält, welche ein wasserlösliches Polymer und zumindest eines aus (a) einer oder mehrerer Arten eines Metallalkoxids und / oder eines hydrolysierten Produkts davon und (b) Zinnchlorid enthält, und Trocknen des Beschichtungsagens **durch** Erwärmen.

5. Laminierte transparenter Gasbarrierefilm nach Anspruch 4, **dadurch gekennzeichnet, dass** das Metallalkoxid zumindest eines aus Tetraethoxysilan und Triisopropoxyaluminium enthält.

6. Laminierter transparenter Gasbarrierefilm nach Anspruch 4 oder 5, **dadurch gekennzeichnet, dass** das wasserlösliche Polymer Polyvinylalkohol ist.

7. Laminierter transparenter Gasbarrierefilm nach einem der Ansprüche 1 bis 6, **gekennzeichnet durch** ferner Umfassen einer Wärmeversiegelungsschicht, die auf zumindest einem der ersten und zweiten transparenten Gasbarrierefilme gebildet ist.

8. Elektrolumineszentes lichtemittierendes Element, **gekennzeichnet durch** Umfassen einer laminierten Struktur, die eine transparente Elektrodenschicht, eine elektrolumineszente lichtemittierende Schicht, die auf der transparenten Elektronenschicht gebildet ist, eines aus einer dielektrischen Schicht und isolierenden Schicht, die auf der elektrolumineszenten lichtemittierenden Schicht gebildet ist, und eine Rückelektrodenschicht, die auf einer aus der dielektrischen Schicht oder der isolierenden Schicht gebildet ist, beinhaltet, und eines laminierten transparenten Gasbarrierefilms nach einem der Ansprüche 1 bis 7 und versiegelt ist, um die laminierte Struktur zu bedecken.

9. Elektrolumineszente Anzeigevorrichtung, **gekennzeichnet durch** Umfassen eines elektrolumineszenten lichtemittierenden Elements nach Anspruch 8, und einer Farbfilterschicht, die zwischen der transparenten Elektrodenschicht und dem laminierten transparenten Gasbarrierefilm auf der transparenten Elektrodenschicht gebildet ist.

10. Elektrophoretisches Anzeigepanel, **gekennzeichnet durch** Umfassen einer Anzeigeeinheit, die eine transparente Elektrodenschicht, einen Anzeigebereich, der elektrophoretische Teilchen und eine isolierende Flüssigkeit enthält, welche die elektrophoretischen Teilchen dispergiert, und einer Rückelektrode, die auf dem Anzeigebereich gebildet ist, beinhaltet, und eines laminierten transparenten Gasbarrierefilms nach einem der Ansprüche 1 bis 7 und versiegelt ist, um die Anzeigeeinheit zu bedecken.

11. Elektrophoretisches Anzeigepanel nach Anspruch 10, **dadurch gekennzeichnet, dass** die Anzeigeeinheit eine Kapsel aufweist, die die isolierende Flüssigkeit, in welcher die elektrophoretischen Teilchen dispergiert sind, einkapselt.

## Revendications

1. Film stratifié transparent de barrière de gaz comportant un premier film transparent de barrière de gaz, un couche auto-adhésive de 1 à 30 ·m d'épaisseur formée sur le premier film transparent de barrière de gaz, et un deuxième film transparent de barrière de gaz formé sur la couche auto-adhésive,
ledit film stratifié transparent de barrière de gaz étant **caractérisé en ce que** au moins un des premier et deuxième films transparents de barrière de gaz comporte une matière de base, et une couche déposée d'oxyde minéral déposée sur la matière de base.

2. Film stratifié transparent de barrière de gaz selon la revendication 1, **caractérisé en ce que** le premier film transparent de barrière de gaz comporte une matière de base, et une couche déposée d'oxyde minéral formée sur la matière de base, et le deuxième film transparent de barrière de gaz comporte une couche de résine de barrière de gaz.

3. Film stratifié transparent de barrière de gaz selon la revendication 1 ou 2, **caractérisé en ce que** l'oxyde minéral contient au moins un élément choisi dans le groupe de l'oxyde d'aluminium, de l'oxyde de silicium, et de l'oxyde de magnésium.

4. Film stratifié transparent de barrière de gaz selon l'une quelconque des revendications 1 à 3, **caractérisé en ce qu'**il comporte en outre, sur la couche déposée d'oxyde minéral, une couche de revêtement de barrière de gaz formée en appliquant un agent de revêtement contenant, en tant qu'agent principal, l'un d'une solution aqueuse et d'un mélange de solution aqueuse/alcoolique qui continent un polymère soluble dans l'eau et au moins un de (a) un ou plusieurs types d'un alkoxide métallique et/ou d'un produit hydrolysé de celui-ci et (b) du chlorure d'étain, et en séchant l'agent de revêtement par chauffage.

5. Film stratifié transparent de barrière de gaz selon la revendication 4, **caractérisé en ce que** l'alkoxide métallique contient au moins un du tétraéthoxysilane et du triisopropoxy aluminium.

6. Film stratifié transparent de barrière de gaz selon la revendication 4 ou 5, **caractérisé en ce que** le polymère soluble dans l'eau est de l'alcool polyvinylique.

7. Film stratifié transparent de barrière de gaz selon l'une quelconque des revendications 1 à 6, **caractérisé en ce qu'**il comporte en outre une couche de scellage à chaud formée sur au moins un des premier et deuxième films transparents de barrière de gaz.

8. Un élément d'émission de lumière électroluminescent **caractérisé en ce qu'**il comporte une structure stratifiée comprenant une couche d'électrode transparente, une couche d'émission de lumière électroluminescente formée sur la couche d'électrode transparente, une d'une couche diélectrique et d'une couche d'isolation formée sur la couche d'émission de lumière électroluminescente, et une couche arrière d'électrode formée sur une de la couche diélectrique et de la couche d'isolation, et un film stratifié transparent de barrière de gaz selon l'une quelconque des revendications 1 à 7 et scellé afin de recouvrir la structure stratifiée.

9. Dispositif d'affichage électroluminescent **caractérisé en ce qu'**il comporte un élément d'émission de lumière électroluminescent selon la revendication 8, et une couche de filtre de couleur formée entre la couche d'électrode transparente et le film stratifié transparent de barrière de gaz sur la couche d'électrode transparente.

10. Panneau d'affichage électrophorétique **caractérisé en ce qu'**il comporte une unité d'affichage comprenant une couche d'électrode transparente, une zone d'affichage contenant des particules électrophorétiques et un fluide isolant qui disperse les particules électrophorétiques, et une électrode arrière formée sur la zone d'affichage,
et un film stratifié transparent de barrière de gaz selon l'une quelconque des revendications 1 à 7 et scellé afin de recouvrir l'unité d'affichage.

11. Panneau d'affichage électrophorétique selon la revendication 10, **caractérisée en ce que** l'unité d'affichage a une capsule qui enferme le fluide isolant dans lequel les particules électrophorétiques sont dispersées.
